# FASCICULE DE BREVET EUROPEEN

(11) **EP 0 511 046 B1**
(45) Date de publication et mention de la délivrance du brevet: **27.12.1995**
(21) Numéro de dépôt: 92400981.4
(22) Date de dépôt: 08.04.1992
(51) Int. Cl.: G01R 33/12, G01R 27/26

(54) **Dispositif pour l'estimation, à température élevée, des caratéristiques életromagnétiques d'un matériau**
Anordnung für das Schätzen von elektromagnetischen Eigenschaften eines Materials bei höheren Temperaturen
Device for estimating electromagnetic properties of a material at elevated temperatures

(30) Priorité: 19.04.1991 FR 9104851
(43) Date de publication de la demande: 28.10.1992
(73) Titulaire: AEROSPATIALE Société Nationale Industrielle, 75781 Paris Cédex 16 (FR)
(72) Inventeur: Lahitte, Pierre Victor André, F-33160 Salaunes (FR); Grenot, Michel, F-33160 Saint Medard en Jalles (FR); Bratières, Jean-Yves, F-33700 Merignac (FR); Prache,Brigitte, F-33000 Bordeaux (FR)
(74) Mandataire: Bonnetat, Christian

(56) Documents cités:
- EP-A- 0 307 261
- EP-A- 0 418 117
- US-A- 4 996 489
- ANTENNAS AND PROPAGATION SOCIETY SYMPOSIUM, 1991 DIGEST vol. 3, 1991, CANADA
- pages 1672 - 1675; P. FRIEDERICH ET AL.: '"Elevated temperature measurements of permittivity and permeability at temperatures above 1000 C'
- MICROWAVE JOURNAL. vol. 33, no. 10, Octobre 1990, NORWOOD US pages 77 - 88; G. MAZE ET AL.: 'Microwave measurement of the dielectric constant using a sliding short-circuited waveguide method'
- IEEE INSTRUMENTATION AND MEASUREMENT TECHNOLOGY CONFERENCE,13-15 février 1990, San José, CA USA pages 115-118 H.A. BUCKMASTER et al.: 'Design optimization of a high precision microwave complex permittivity instrumentation system fo use with high loss liquids'

## Description

La présente invention concerne un dispositif pour l'estimation, à température élevée, des caractéristiques électromagnétiques d'un matériau diélectrique ou magnétique, essentiellement sa permittivité et/ou sa perméabilité relatives.

La connaissance de ces caractéristiques électromagnétiques est particulièrement importante dans le domaine aéronautique ou spatial, car de telles caractéristiques déterminent le comportement électromagnétique du matériau. Par exemple, une telle connaissance permet de juger de la réponse radar d'un aéronef ou de la transmission de signaux à travers le fuselage. Ainsi, pour caractériser le comportement électromagnétique d'un tel matériau, il est nécessaire de connaître lesdites caractéristiques électromagnétiques.

Par exemple, par le document ALTA FREQUENZA, vol. 36, n° 8, août 1967, pages 757-764, Milan, IT ; G. FRANCESCHETTI : "A complete analysis of the reflection and transmission methods for measuring the complex permeability and permittivity of materials at microwaves" , on connaît une méthode pour déterminer les caractéristiques électromagnétiques d'un matériau, à partir d'échantillons de celui-ci introduits dans un appareil électromagnétique tel qu'une ligne coaxiale ou un guide d'ondes. Les mesures peuvent être effectuées à la température ambiante ou bien à température élevée (jusqu'à 2000°C), comme cela est indiqué dans le document MICROWAVE JOURNAL, février 1991, pages 67 et suivantes ; Rick L. MOORE, Anita MAC DONALD et H. Ross MOROZ : "Permittivity of Fiber-Polymer Composites : A study to determine the effects of the environment".

Dans le cas où les mesures sont effectuées à température élevée, il est nécessaire de disposer ledit appareil électromagnétique dans un four. Il en résulte alors des difficultés de chargement et de déchargement des échantillons dudit matériau dans ledit appareil électromagnétique.

La présente invention a pour objet un dispositif pour l'estimation, à température élevée, des caractéristiques d'un matériau diélectrique ou magnétique, permettant un chargement et un déchargement aisés desdits échantillons. Un dispositif analogue à celui décrit dans le préambule de la revendication 1 est par exemple connu du document EP-A-0 307 261.

A cette fin, selon l'invention, le dispositif pour l'estimation, à température élevée, des caractéristiques électromagnétiques d'un matériau, comportant :
- un four ;
- un appareil électromagnétique de mesure, disposé au moins en partie dans ledit four et comportant, dans cette dernière partie, un logement pour une pièce échantillon d'épaisseur uniforme façonnée dans ledit matériau, cette pièce échantillon étant telle que, lorsqu'elle est disposée dans ledit logement, sa périphérie extérieure épouse la surface intérieure dudit appareil électromagnétique de mesure ;
- des moyens pour appliquer audit appareil électromagnétique de mesure une onde électromagnétique à hyperfréquence incidente ; et
- des moyens pour recueillir l'onde électromagnétique transmise par ladite pièce échantillon ;

est remarquable en ce que ledit appareil électromagnétique de mesure est un guide d'ondes métallique creux disposé verticalement et en ce que ledit logement est prévu à l'extrémité inférieure ouverte dudit guide d'ondes, le coefficient de dilatation thermique du métal dudit guide d'onde est plus grand que celui du matériau de ladite pièce échantillon.

Ainsi, il est possible d'introduire ladite pièce échantillon dans le guide d'ondes par un simple mouvement d'élévation et de l'en extraire en laissant agir la pesanteur. Une telle extraction naturelle est permise par le fait que la dilatation du guide d'ondes (réalisé en un métal tel que le molybdène ou le tungstène) est généralement supérieure à celle de la pièce échantillon dont on mesure les caractéristiques électromagnétiques. Eventuellement, dans la mesure de celles-ci, on fait intervenir un terme correctif tenant compte du jeu apparaissant entre le contour de ladite pièce échantillon et la paroi interne dudit guide d'ondes. On remarquera que, puisque l'appareil électromagnétique est un guide d'ondes --donc une enveloppe tubulaire creuse--, la mise en place et l'extraction de la pièce échantillon sont facilitées, puisqu'il n'existe pas d'âme centrale, comme ce serait le cas avec une ligne coaxiale. Il résulte également du choix d'un guide d'ondes comme appareil électromagnétique que la répartition de la chaleur dans la pièce échantillon est particulièrement bonne et homogène, et meilleure que celle qui serait obtenue avec une ligne coaxiale, dont l'âme centrale perturbe une telle répartition de chaleur en la rendant hétérogène à l'intérieur de ladite pièce échantillon.

De préférence, le dispositif selon l'invention comporte de plus une plaquette électromagnétiquement conductrice s'appliquant contre l'extrémité inférieure ouverte dudit guide d'ondes et susceptible de supporter ladite pièce échantillon pendant les mesures. Ainsi, ladite plaquette forme un court-circuit pour ledit guide d'ondes.

Afin que les mesures soient aussi précises que possible, l'extrémité inférieure ouverte du guide d'ondes est extérieurement biseautée. Ainsi, la surface de contact entre le guide d'ondes et ladite plaquette est réduite et l'application de cette dernière contre le guide d'ondes est améliorée.

Avantageusement, ladite plaquette est guidée en coulissement vertical par rapport au guide d'ondes. Il est avantageux qu'un tel coulissement s'effectue sous l'action d'un vérin ou analogue.

Pour mettre en place la pièce échantillon dans son logement, il est avantageux de prévoir des moyens supportant temporairement ladite pièce échantillon et centrés par rapport à la surface extérieure dudit guide d'ondes. Ainsi, il est possible d'introduire facilement ladite pièce échantillon dans son logement et, ladite plaquette étant élevée en une position proche de la position d'obturation dudit guide d'ondes, d'éliminer lesdits moyens de support en déposant ladite pièce échantillon sur ladite plaquette, celle-ci restant engagée dans son logement.

Afin d'éviter toute pollution de la pièce échantillon pendant les mesures, on prévoit un four de type électrique permettant de plus d'obtenir une large gamme de températures. Celui-ci peut, selon une particularité de l'invention, comporter une enceinte thermique enfermant une enveloppe chauffante, mobile verticalement entre une position rétractée, pour laquelle elle dégage l'extrémité inférieure dudit guide d'ondes pour permettre la mise en place et l'extraction de la pièce échantillon et une position saillante, pour laquelle elle entoure ladite extrémité inférieure dudit guide d'ondes. Cette position saillante correspond notamment à la position de chauffage, de sorte que la pièce échantillon se trouve entourée alors par ladite enveloppe chauffante, ce qui permet un chauffage particulièrement efficace et homogène. Pour déplacer verticalement ladite enveloppe chauffante, on prévoit des moyens moteurs, tels qu'un vérin ou analogue. Il est avantageux que lesdits moyens moteurs, pendant les mesures, pressent ladite plaquette contre l'extrémité inférieure dudit guide d'ondes.

De préférence, la pression desdits moyens moteurs sur ladite plaquette s'exerce par l'intermédiaire d'une tige mobile verticalement associée à un capteur de pression. Ainsi, pendant la mesure, la pression de la plaquette contre le guide d'ondes peut être maintenue constante, bien que la malléabilité du guide d'ondes varie avec la température. Grâce à une telle particularité, la précision des mesures est encore améliorée.

Pour améliorer encore plus l'homogénéité de la répartition de la pression exercée par la plaquette contre l'extrémité ouverte du guide d'ondes, ladite tige presse ladite plaquette par l'intermédiaire d'une rotule prenant appui approximativement au centre de ladite plaquette.

Selon encore une autre particularité de la présente invention, on prévoit un système de pelle et de poussoir, actionnable depuis l'extérieur du four et permettant d'évacuer la pièce échantillon de ladite plaquette, lorsque celle-ci est écartée dudit guide d'ondes. Cette particularité permet un mode opératoire particulièrement avantageux du dispositif conforme à l'invention. On sait en effet que les mesures des caractéristiques électromagnétiques d'une pièce échantillon nécessite des mesures identiques à vide (sans ladite pièce échantillon) et avec ladite pièce échantillon, lesdites caractéristiques étant déduites de la comparaison desdites mesures. Grâce au système de pelle et de poussoir et en commençant les mesures relatives à l'échantillon, il est possible d'effectuer les mesures à vide sans ouvrir le four et sans avoir à recommencer un cycle de montée en température. Ainsi, avec un seul cycle de montée en température, on peut effectuer les mesures relatives à la pièce échantillon, puis les mesures à vide. Le temps total des mesures est donc considérablement raccourci.

De façon connue, le dispositif peut comporter de plus des appareils et détecteurs auxiliaires tels que :
. pompe à vide pour effectuer le vide à l'intérieur dudit four et réduire ainsi des pollutions de la pièce échantillon ;
. réservoirs de gaz neutre, pour effectuer le balayage du four ;
. dispositif de refroidissement de l'enceinte du four ;
. capteur de température ;
. jauge à vide, etc ...

Pour piloter ces différents appareils et détecteurs auxiliaires, ainsi que le vérin de coulissement vertical de la plaquette et lesdits moyens moteurs, il est avantageux de prévoir une première calculatrice. Une seconde calculatrice peut être prévue pour commander ledit appareil électromagnétique et effectuer les mesures relatives à celui-ci.

Les figures du dessin annexé feront bien comprendre comment l'invention peut être réalisée. Sur ces figures, des références identiques désignent des éléments semblables.

La figure 1 est le schéma synoptique, au repos, du dispositif conforme à la présente invention, le four y étant représenté en coupe.

Les figures 2A à 2E sont des coupes verticales de l'extrémité inférieure du guide d'ondes, illustrant la mise en place d'une pièce échantillon dans ledit guide d'ondes, dans un plan perpendiculaire à celui de la figure 1.

La figure 3 est une coupe horizontale, selon la ligne III-III de la figure 2A.

La figure 4 est un schéma synoptique semblable à celui de la figure 1, le four étant dans une phase de chauffage.

Les figures 5A et 5B sont des coupes verticales de l'extrémité inférieure du guide d'ondes, illustrant l'élimination de ladite pièce échantillon, le plan des figures 5A et 5B étant perpendiculaire à celui des figures 2A à 2E.

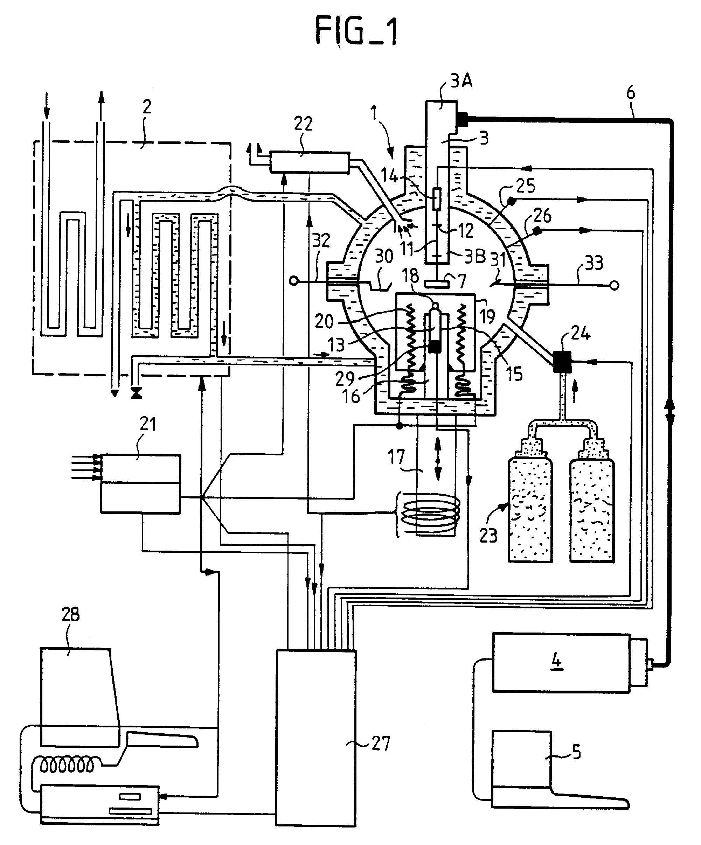

Le dispositif conforme à la présente invention, montré schématiquement sur la figure 1, comporte une enceinte thermique à double paroi 1, parcourue par un fluide de refroidissement traversant un système de refroidissement 2. A la partie supérieure de l'enceinte thermique 1 est disposé un guide d'ondes vertical 3, traversant ladite enceinte de façon étanche. La partie supérieure 3A dudit guide d'ondes, extérieure à l'enceinte thermique 1, est reliée à un analyseur de réseau 4 et à une calculatrice 5 par l'intermédiaire d'un câble coaxial 6. L'ensemble 4-5-6 forme le dispositif d'alimentation du guide d'ondes 3 en ondes électromagnétiques et le dispositif d'analyse des ondes électromagnétiques parcourant ledit guide d'ondes 3.

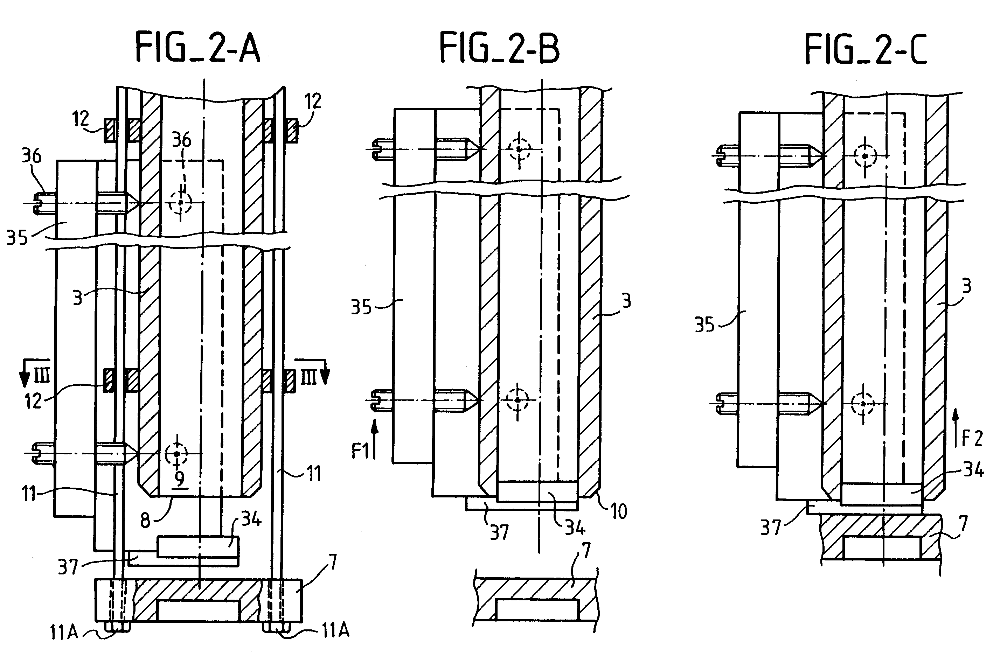

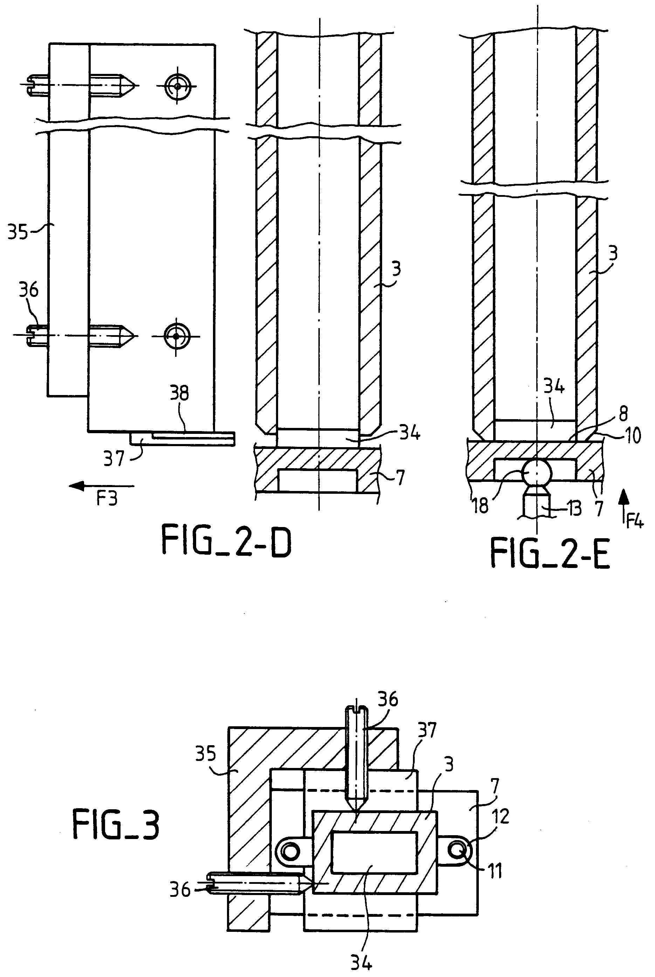

La partie inférieure 3B du guide d'ondes 3, intérieure à l'enceinte thermique 1, est ouverte et peut être obturée par une plaquette 7, susceptible de venir s'appliquer contre les bords 8 de l'ouverture inférieure 9 du guide d'ondes 3 (voir la figure 2E). Pour assurer l'uniformité du contact entre la plaquette 7 et les bords 8 de l'ouverture 9, ces dernières sont extérieurement biseautées (en 10).

Le guide d'ondes 3 peut par exemple être réalisé en tôle de molybdène ou de tungstène. Sur les figures, le guide d'ondes 3 est représenté avec une section rectangulaire.

Comme le montrent plus en détail les figures 2A et 2E (dont le plan est perpendiculaire au plan de la figure 1), la plaquette 7 est suspendue à des tiges 11 par rapport auxquelles elle peut coulisser, lesdites tiges Il coulissant elles-même dans des paliers de coulissement 12, fixés sur la paroi extérieure du guide d'ondes 3. La plaquette 7, retenue sur les tiges 11 par des butées 11A, est susceptible d'être poussée vers le haut par une tige 13 en coulissant le long desdites tiges 11, pour venir s'appliquer contre l'ouverture inférieure 9 de ce dernier.

Les tiges de suspension 11 peuvent coulisser dans les paliers 12 sous l'action d'un vérin 14, par exemple de type pneumatique. La tige de support 13 est logée, à la manière d'un piston, dans un cylindre 15 prévu à l'extrémité de la tige de piston 16 d'un vérin 17, par exemple électrique. Le vérin 17 est disposé à la partie inférieure de l'enceinte thermique 1, à l'extérieur de celle-ci. Sa tige 16 traverse ladite enceinte de façon étanche et est disposée verticalement, en regard du guide d'ondes 3.

La tige 13 est susceptible de prendre appui sous la plaquette 7, au voisinage de son centre, par l'intermédiaire d'une rotule 18. Ainsi, l'uniformité du contact entre la plaquette 7 et les bords 8 de l'ouverture 9 peut encore être améliorée, en profitant du jeu inévitable des tiges 11 dans les paliers 12 et dans la plaquette 7.

Sur la tige 16 du vérin 17, est fixée une enveloppe cylindrique coaxiale 19, dont la paroi porte des résistances électriques 20.

Le dispositif de la figure 1 comporte de plus :
- une alimentation électrique 21 ;
- un dispositif de pompage 22 pour faire le vide dans l'enceinte 1 ;
- un dispositif 23 pour introduire un gaz neutre dans l'enceinte 1, par l'intermédiaire d'une électrovanne 24 ;
- une jauge à vide 25 et un thermocouple 26 pour mesurer le vide et la température à l'intérieur de l'enceinte 1 ; et
- une unité de commande et de contrôle de four 27, pilotée par une calculatrice 28.

Par ailleurs, un détecteur de pression 29 est disposé entre le fond du cylindre 15 et la tige 13, tandis qu'une pelle 30 et un poussoir 31 sont respectivement solidaires de barres de commande 32 et 33, traversant l'enceinte 1 de façon étanche.

Dans la phase initiale d'un cycle de mesure, le dispositif conforme à l'invention se trouve dans l'état représenté sur la figure 1, c'est-à-dire que :
- la plaquette 7 est écartée de l'extrémité inférieure 3B du guide d'ondes 3, suspendue à celui-ci par les tiges 11 et les butées 11A ;
- la tige 16 du vérin 17 est rétractée, de sorte que la plaquette 7 se trouve à l'extérieur de l'enveloppe 19, au-dessus de celle-ci ;
- le système de pelle 30 et de poussoir 31 est rétracté latéralement.

Dans cet état initial, l'ouverture inférieure 9 du guide d'ondes 3 est donc dégagée et on peut y introduire une pièce échantillon 34 du matériau à étudier, de la façon illustrée par les figures 2A à 2E et 3. Le plan des figures 2A à 2E est perpendiculaire à celui de la figure 1 et, pour des raisons de simplicité de dessin, les tiges 11 et les paliers 12 n'ont pas été représentés sur les figures 2B à 2E.

Pour mettre en place la pièce échantillon 34 dans l'ouverture 9, prévue à la partie inférieure du guide d'ondes 3, l'enceinte 1 étant ouverte, on utilise une équerre 35, susceptible de prendre appui sur deux faces extérieures consécutives dudit guide d'ondes 3, par exemple par l'intermédiaire de vis de réglage 36. A la partie inférieure de ladite équerre 35, le dièdre de celle-ci est partiellement obturé par une lame mince 37 comportant l'empreinte 38 de la pièce échantillon 34.

Ainsi, la pièce échantillon 34 peut être disposée de façon précise sur la lame mince 37 grâce à l'empreinte 38 et ladite lame mince 37 peut être disposée de façon précise, entre l'ouverture inférieure 9 du guide d'ondes 3 et la plaquette 7, grâce aux vis de réglage 36.

Comme le montre la figure 2A, grâce à l'équerre 35 et à la lame mince 37, la pièce échantillon 34 peut être disposée juste en regard de l'ouverture inférieure 9, mais au-dessus de la plaquette 7.

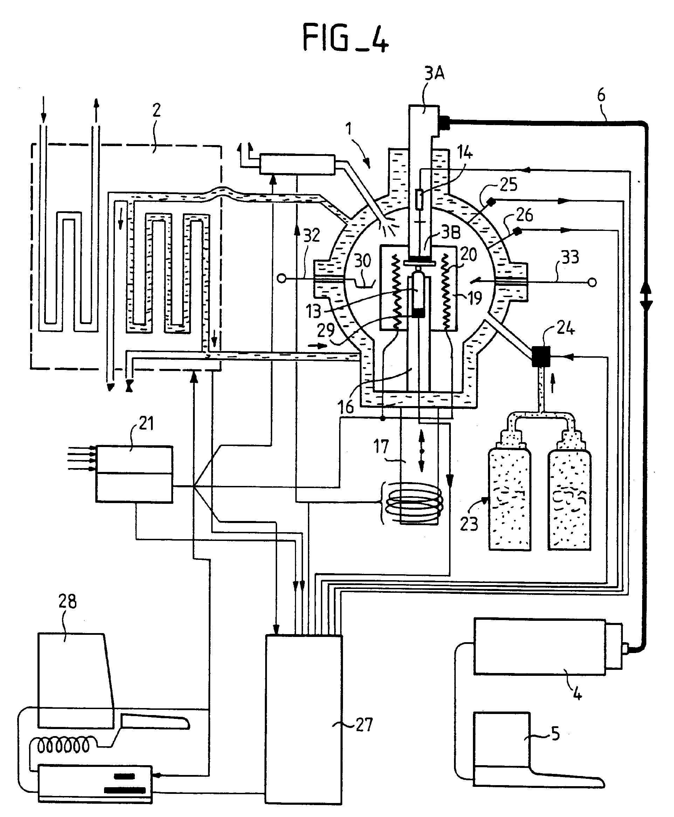

Par suite, en coulissant (flèche F1) l'équerre 35 vers le haut tout en maintenant le contact entre celle-ci et la paroi extérieure du guide d'ondes 3, il est possible d'introduire avec précision la pièce échantillon 34 à l'intérieur de l'ouverture inférieure 9 du guide d'ondes 3, jusqu'à ce que la lame mince 37 vienne en appui contre le bord 8 de ladite ouverture 9 (figure 2B). Dans cette position, on commande le vérin 14 pour qu'il tire les tiges 11 vers le haut (flèche F2), jusqu'à ce que la plaquette 7 vienne juste au-dessous de la lame mince 37, sans la presser (figures 2C). On peut alors retirer latéralement l'équerre 35 et la lame mince 37 (flèche F3), la pièce échantillon 34 restant à l'intérieur de l'ouverture 9, mais reposant maintenant sur la plaquette 7 (figure 2D). Enfin, le vérin 17 est actionné, de sorte que sa tige 16 se déplace verticalement vers le haut (flèche F4) entraînant la tige 13 dans son mouvement ascendant et que la rotule 18 vient presser la plaquette 7 contre le bord 8 de l'ouverture 9 (figure 2E). Au cours de la montée de la tige 16, l'enveloppe chauffante 19, solidaire de celle-ci, est venue se placer autour de l'extrémité inférieure 3B du guide d'ondes 3 (figure 4).

Après avoir refermé l'enceinte 1, on peut alors procéder, de façon connue et sous la dépendance de la calculatrice 28 et de l'unité de commande 27, à la mise sous vide et à la montée en température de l'enceinte 1. La température de mesure désirée étant atteinte et maintenue, on effectue alors, sous la dépendance de la calculatrice 5 et de l'analyseur 4, les mesures concernant la pièce échantillon 34.

On remarquera que, grâce au détecteur de pression 29, on peut asservir le vérin 17 pour que la pression exercée par la plaquette 7 sur le bord inférieur 8 du guide d'ondes 3 soit constante.

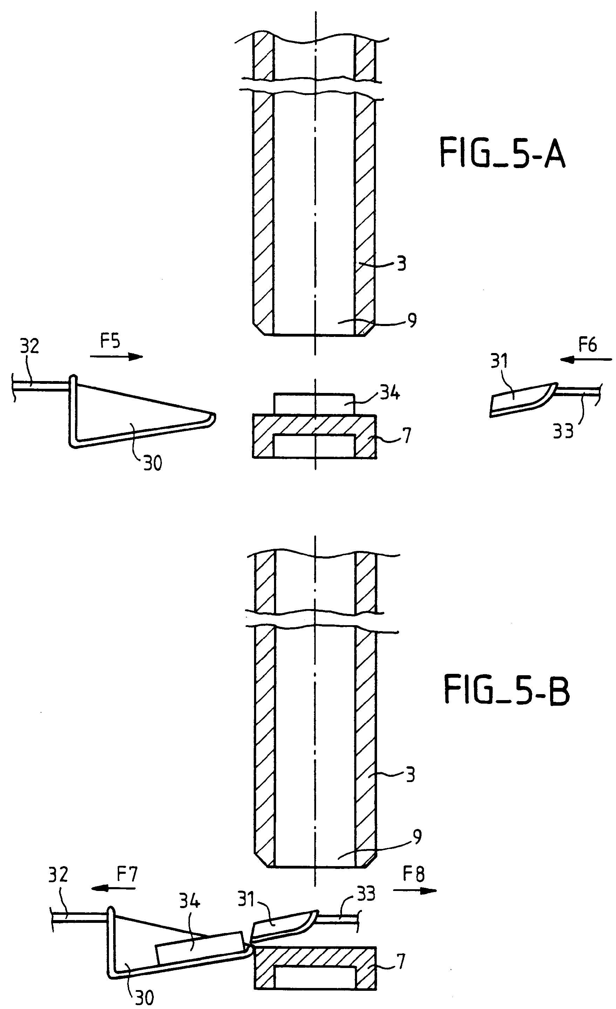

Lorsque les mesures nécessaires ont été effectuées, sans ouvrir l'enceinte 1, on commande le vérin 17, puis le vérin 14, à l'abaissement. Par suite, l'enveloppe chauffante 19 et la plaquette 7 s'abaissent ; la pièce échantillon 34 sort de l'ouverture 9 du guide d'ondes en restant supportée par ladite plaquette 7. Lorsque celle-ci atteint un niveau prédéterminé, le système de pelle 30 et de poussoir 31 est actionné par les tiges 32 et 33 pour se rapprocher (flèches F5 et F6) de la pièce échantillon 34 (figure 5A). Le rapprochement continuant, le poussoir 31 peut éjecter la pièce échantillon 34 dans la pelle 30 (figure 5B). Par commande des tiges 32 et 33 en sens inverse (flèches F7 et F8), on peut rétracter latéralement la pelle 30 et le poussoir 31, pour dégager à nouveau la partie centrale de l'enceinte 1.

On commande alors de nouveau les vérins 14 et 17 à l'élévation pour reprendre les positions relatives des figures 2E et 4, mais sans pièce échantillon 34. Il est alors possible de procéder aux mesures à vide, à partir desquelles on pourra déterminer, par comparaison avec les mesures précédentes, les caractéristiques électromagnétiques du matériau de la pièce échantillon 34.

Dans la description ci-dessus, on n'a décrit que ce qui concerne la présente invention, sans apporter de détail au fonctionnement de la pompe à vide 22, du dispositif de balayage de gaz neutre 23,24 et du dispositif de chauffage et de régulation en température, qui est de la connaissance de l'homme de l'art.

## Revendications

1. Dispositif pour l'estimation, à température élevée, des caractéristiques électromagnétiques d'un matériau, comportant :
- un four (1, 19, 20) ;
- un appareil électromagnétique de mesure (3), disposé au moins en partie dans ledit four et comportant, dans cette dernière partie, un logement (9) pour une pièce échantillon (34) d'épaisseur uniforme façonnée dans ledit matériau, cette pièce échantillon (34) étant telle que, lorsqu'elle est disposée dans ledit logement (9), sa périphérie extérieure épouse la surface intérieure dudit appareil électromagnétique de mesure ;
- des moyens (4,5,6) pour appliquer audit appareil électromagnétique de mesure (3) une onde électromagnétique à hyperfréquence incidente ; et
- des moyens (4,5,6) pour recueillir l'onde électromagnétique transmise par ladite pièce échantillon (34) ;
caractérisé en ce que :
- ledit appareil électromagnétique de mesure (3) est un guide d'ondes métallique creux disposé verticalement ;
- ledit logement (9) est prévu à l'extrémité inférieure ouverte (3B) dudit guide d'ondes (3) ; et
- le coefficient de dilatation thermique du métal dudit guide d'ondes (3) est plus grand que celui du matériau de ladite pièce échantillon (34).

2. Dispositif selon la revendication 1,
caractérisé en ce qu'il comporte une plaquette (7) électromagnétiquement conductrice s'appliquant contre l'extrémité inférieure ouverte dudit guide d'ondes (3) et susceptible de supporter ladite pièce échantillon (34) pendant les mesures.

3. Dispositif selon la revendication 2,
caractérisé en ce que l'extrémité inférieure ouverte dudit guide d'ondes est extérieurement biseautée (en 10).

4. Dispositif selon l'une des revendications 2 ou 3,
caractérisé en ce que ladite plaquette (7) est guidée en coulissement vertical (11,12) par rapport au guide d'ondes (3).

5. Dispositif selon la revendication 4,
caractérisé en ce que ledit coulissement vertical de la plaquette (7) s'effectue sous l'action d'un vérin ou analogue (14).

6. Dispositif selon l'une quelconque des revendications 1 à 5,
caractérisé en ce qu'il comporte des moyens (35,36,37) supportant temporairement ladite pièce échantillon (34) et centrés par rapport à la surface extérieure dudit guide d'ondes (3).

7. Dispositif selon l'une quelconque des revendications 1 à 6,
caractérisé en ce que ledit four est électrique.

8. Dispositif selon la revendication 7,
caractérisé en ce que ledit four comporte une enceinte thermique (1) enfermant une enveloppe chauffante (19,20), mobile verticalement entre une position rétractée, pour laquelle elle dégage l'extrémité inférieure dudit guide d'ondes (3) pour permettre la mise en place et l'extraction de ladite pièce échantillon (34) et une position saillante, pour laquelle elle entoure ladite extrémité inférieure dudit guide d'ondes.

9. Dispositif selon la revendication 8,
caractérisé en ce qu'il comporte des moyens moteurs (16,17) pour déplacer verticalement ladite enveloppe chauffante (19,20).

10. Dispositif selon les revendications 2 et 9,
caractérisé en ce que lesdits moyens moteurs (16,17), pendant les mesures, pressent ladite plaquette (7) contre l'extrémité inférieure dudit guide d'ondes (3).

11. Dispositif selon la revendication 10,
caractérisé en ce que la pression desdits moyens moteurs (16,17) sur ladite plaquette (7) s'exerce par l'intermédiaire d'une tige (13) mobile verticalement associée à un capteur de pression.

12. Dispositif selon la revendication 11,
caractérisé en ce que ladite tige (13) presse ladite plaquette (7) par l'intermédiaire d'une rotule (18) prenant appui approximativement au centre de ladite plaquette (7).

13. Dispositif selon l'une quelconque des revendications 2 à 12,
caractérisé en ce qu'il comporte un système de pelle (30) et de poussoir (31), actionnable depuis l'extérieur du four et permettant d'éliminer la pièce échantillon (34) de ladite plaquette, lorsque celle-ci est écartée dudit guide d'ondes.

14. Dispositif selon les revendications 5 et 9, comportant des appareils et détecteurs auxiliaires (2,22,23, 24,25,26),
caractérisé en ce qu'il comporte des moyens de calcul (27) pour piloter lesdits appareils et détecteurs auxiliaires ainsi que ledit vérin (14) et lesdits moyens moteurs (16,17).

15. Dispositif selon l'une quelconque des revendications 1 à 14,
caractérisé en ce qu'il comporte des moyens de calcul (4,5) pour piloter ledit appareil électromagnétique (3).

## Patentansprüche

1. Vorrichtung für die Bewertung der elektromagnetischen Eigenschaften eines Werkstoffs bei Hochtemperatur, bestehend aus:
- einem Ofen (1, 19, 20);
- einem elektromagnetischen Meßgerät (3), das zumindest zum Teil in dem besagten Ofen angeordnet ist und in diesem letzteren Teil eine Aufnahme (9) für ein aus dem besagten Werkstoff gefertigtes Probestück (34) gleichmäßiger Dicke besitzt, wobei dieses Probestück (34) so beschaffen ist, daß, wenn es in sich in der besagten Aufnahme (9) befindet, sein Außenumfang vollkommen an der Innenfläche des besagten elektromagnetischen Meßgerätes anliegt;
- Mitteln (4, 5, 6), um an das besagte elektromagnetische Meßgerät (3) eine einfallende elektromagnetische Welle mit Höchstfrequenz anzulegen; und
- Mitteln (4, 5, 6) zum Auffangen der von besagtem Probestück (34) übertragenen elektromagnetischen Welle;
dadurch gekennzeichnet daß:
- das besagte elektromagnetische Meßgerät (3) ein senkrecht angeordneter, metallischer hohler Wellenleiter ist;
- die besagte Aufnahme (9) sich am unteren offenen Ende (3B) des besagten Wellenleiters (3) befindet; und
- der Wärmeausdehnungskoeffizient des Metalls des besagten Wellenleiters (3) größer als der des Werkstoffs des besagten Probestücks (34) ist.

2. Vorrichtung gemäß Anspruch 1,
dadurch gekennzeichnet, daß sie eine elektromagnetisch leitende Platte (7) besitzt, die sich gegen das offene untere Ende des besagten Wellenleiters (3) legt und das besagte Probestück (34) während der Messungen tragen kann.

3. Vorrichtung gemäß Anspruch 2,
dadurch gekennzeichnet, daß das offene untere Ende des besagten Wellenleiters außen angefast (10) ist.

4. Vorrichtung gemäß einem der Ansprüche 2 oder 3,
dadurch gekennzeichnet, daß die besagte Platte (7) senkrecht gleitend (11, 12) zum Wellenleiter (3) geführt wird.

5. Vorrichtung gemäß Anspruch 4,
dadurch gekennzeichnet, daß die besagte senkrechte Gleitbewegung der Platte (7) mit Hilfe eines Zylinders oder einer ähnlichen Vorrichtung (14) erfolgt.

6. Vorrichtung gemäß einem beliebigen der Ansprüche 1 bis 5,
dadurch gekennzeichnet, daß sie Mittel (35, 36, 37) umfaßt, die das besagte Probestück (34) zeitweilig tragen und zentrisch zur Außenfläche des besagten Wellenleiters (3) angeordnet sind.

7. Vorrichtung gemäß einem beliebigen der Ansprüche 1 bis 6,
dadurch gekennzeichnet, daß der besagte Ofen ein Elektroofen ist.

8. Vorrichtung gemäß Anspruch 7,
dadurch gekennzeichnet, daß der besagte Ofen eine Wärmekammer (1) umfaßt, die einen Heizmantel (19, 20) umschließt, der vertikal bewegt werden kann zwischen einer zurückgezogenen Stellung, in der er das untere Ende des besagten Wellenleiters (3) freigibt, um das Einbringen und Entfernen des besagten Probestückes (34) zu ermöglichen, und einer vorspringenden Stellung, in der er das besagte untere Ende des genannten Wellenleiters umgibt.

9. Vorrichtung gemäß Anspruch 8,
dadurch gekennzeichnet, daß sie Antriebsmittel (16, 17) zur vertikalen Verschiebung des besagten Heizmantels (19, 20) aufweist.

10. Vorrichtung gemäß Anspruch 2 und 9,
dadurch gekennzeichnet, daß die besagten Antriebsmittel (16, 17) die besagte Platte (7) während der Messungen gegen das untere Ende des genannten Wellenleiters (3) drücken.

11. Vorrichtung gemäß Anspruch 10,
dadurch gekennzeichnet, daß der Druck der besagten Antriebsmittel (16, 17) auf die genannte Platte (7) über eine vertikal bewegliche Stange (13) erfolgt, die mit einem Druckgeber verbunden ist.

12. Vorrichtung gemäß Anspruch 11,
dadurch gekennzeichnet, daß die besagte Stange (13) die besagte Platte (7) mittels eines Kugelkopfes (18) andrückt, der ungefähr im Mittelpunkt der besagten Platte (7) ansetzt.

13. Vorrichtung gemäß einem beliebigen der Ansprüche 2 bis 12,
dadurch gekennzeichnet, daß sie ein System mit Schaufel (30) und Schieber (31) umfaßt, das von außerhalb des Ofens betätigt wird und mit dem das Probestück (34) von der besagten Platte entfernt werden kann, wenn diese vom besagten Wellenleiter weggeführt ist.

14. Vorrichtung gemäß den Ansprüchen 5 und 9, die Hilfsgeräte und -anzeiger (2, 22, 23, 24, 25, 26) umfaßt,
dadurch gekennzeichnet, daß sie Rechengeräte (27) zur Steuerung der besagten Hilfsgeräte und -anzeiger sowie des besagten Zylinders (14) und der besagten Antriebsmittel (16,17) besitzt.

15. Vorrichtung gemäß einem beliebigen der Ansprüche 1 bis 14,
dadurch gekennzeichnet, daß sie Rechengeräte (4, 5) zur Steuerung des besagten elektromagnetischen Gerätes (3) umfaßt.

## Claims

1. Device for estimating, at high temperature, the electromagnetic properties of a material, comprising:
- an oven (1, 19, 20);
- an electromagnetic measurement apparatus (3), disposed at least in part in the said oven and comprising, in this latter part, a housing (9) for a specimen piece (34) of uniform thickness made in the said material, this specimen piece (34) being such that, when it is disposed in the said housing (9), its outer periphery matches the inner surface of the said electromagnetic measurement apparatus;
- means (4, 5, 6) for applying an incident very high frequency electromagnetic wave to the said electromagnetic measurement apparatus (3); and
- means (4, 5, 6) for collecting the electromagnetic wave transmitted by the said specimen piece (34);
characterized in that
- the said electromagnetic measurement apparatus (3) is a vertically disposed hollow metallic waveguide;
- the said housing (9) is provided at the open lower end (3B) of the said waveguide (3); and
- the coefficient of thermal expansion of the metal of the said waveguide (3) is greater than that of the material of the said specimen piece (34).

2. Device according to Claim 1, characterized in that it comprises an electromagnetically conductive small plate (7) which is applied against the open lower end of the said waveguide (3) and is capable of supporting the said specimen piece (34) during the measurements.

3. Device according to Claim 2, characterized in that the open lower end of the said waveguide is bevelled on the outside (at 10).

4. Device according to either Claim 2 or 3, characterized in that the said small plate (7) is guided so as to slide vertically (11, 12) in relation to the waveguide (3).

5. Device according to Claim 4, characterized in that the said vertical sliding of the small plate (7) is carried out under the action of a thrust device or the like (14).

6. Device according to any one of Claims 1 to 5, characterized in that it comprises means (35, 36, 37) which temporarily support the said specimen piece (34) and which are centred in relation to the outer surface of the said waveguide (3).

7. Device according to any one of Claims 1 to 6, characterized in that the said oven is of electrical type.

8. Device according to Claim 7, characterized in that the said oven comprises a thermal enclosure (1) enclosing a heating jacket (19, 20), movable vertically between a retracted position, in which it is clear of the lower end of the said waveguide (3) in order to enable the said specimen piece (34) to be installed and extracted, and a projecting position, in which it surrounds the said lower end of the said waveguide.

9. Device according to Claim 8, characterized in that it comprises driving means (16, 17) in order to move the said heating jacket (19, 20) vertically.

10. Device according to Claims 2 and 9, characterized in that the said driving means (16, 17), during the measurements, press the said small plate (7) against the lower end of the said waveguide (3).

11. Device according to Claim 10, characterized in that the pressure of the said driving means (16, 17) on the said small plate (7) is exerted by the agency of a vertically movable rod (13) associated with a pressure sensor.

12. Device according to Claim 11, characterized in that the said rod (13) presses the said small plate (7) by the agency of a ball (18) which bears approximately at the centre of the said small plate (7).

13. Device according to any one of Claims 2 to 12, characterized in that it comprises a scoop (30) and pusher (31) system which can be activated from outside the oven and which enables the specimen piece (34) to be removed from the said small plate when the latter is away from the said waveguide.

14. Device according to Claims 5 and 9, comprising auxiliary apparatuses and detectors (2, 22, 23, 24, 25, 26), characterized in that it comprises computing means (27) in order to control the said auxiliary apparatuses and detectors as well as the said thrust device (14) and the said driving means (16, 17).

15. Device according to any one of Claims 1 to 14, characterized in that it comprises computing means (4, 5) in order to control the said electromagnetic apparatus (3).
